**Europäisches Patentamt**

**European Patent Office**

**Office européen des brevets**

(19)

(11) Veröffentlichungsnummer : **0 329 652 B1**

(12)

# EUROPÄISCHE PATENTSCHRIFT

(45) Veröffentlichungstag der Patentschrift :
03.06.92 Patentblatt 92/23

(51) Int. Cl.$^5$ : **G01R 33/04**

(21) Anmeldenummer : **87904847.8**

(22) Anmeldetag : **06.08.87**

(86) Internationale Anmeldenummer :
**PCT/DE87/00346**

(87) Internationale Veröffentlichungsnummer :
**WO 88/03654 19.05.88 Gazette 88/11**

(54) **VORRICHTUNG ZUR MESSUNG EINES ZEITLICH KONSTANTEN ODER SICH ÄNDERNDEN MAGNETFELDES.**

(30) Priorität : **06.11.86 DE 3637801**

(43) Veröffentlichungstag der Anmeldung :
**30.08.89 Patentblatt 89/35**

(45) Bekanntmachung des Hinweises auf die
Patenterteilung :
**03.06.92 Patentblatt 92/23**

(84) Benannte Vertragsstaaten :
**DE FR IT**

(56) Entgegenhaltungen :
**EP-A- 0 155 324**
**DE-B- 1 234 848**
**US-A- 4 321 536**

(73) Patentinhaber : **ROBERT BOSCH GMBH**
**Postfach 30 02 20**
**W-7000 Stuttgart 30 (DE)**

(72) Erfinder : **ECKARDT, Dieter**
**Gibitzenhofstrasse 17**
**W-8500 Nürnberg (DE)**
Erfinder : **HETTICH, Gerhard**
**Martin-Renz-Strasse 8**
**W-8501 Dietenhofen (DE)**

Jouve, 18, rue Saint-Denis, 75001 PARIS

## Beschreibung

Die Erfindung richtet sich auf eine Vorrichtung zur Messung eines zeitlich konstanten oder sich ändernden Magnetfeldes umfassend wenigstens einen Kern aus einem Material mit hoher Permeabilität, eine Spule zur Magnetisierung dieses Kerns über eine an die Spule angeschlossene Wechselstromquelle und eine Meß-Spule, in welcher eine Spannung induziert wird entsprechend dem in dem Kern aufgrund des durch den angelegten Wechselstrom und das äußere, zu messende Magnetfeld erzeugten resultierenden Magnetfeld.

Eine derartige Vorrichtung ist aus der DE-A-33 45 712 bekannt. Bei dieser vorbekannten Vorrichtung, die insbesondere zur Messung der Richtung des Erdfeldes dient, wird der Kern durch einen Wechselstrom wechselweise bis in die Sättigung magnetisiert. Dabei bildet der Grad der Abweichung zwischen der Dauer der positiven und negativen Halbwellen der Meßspannung ein Maß für die Größe des gemessenen Magnetfeldes, indem der Kern aufgrund des zu messenden äußeren Magnetfeldes in einer Magnetisierungsrichtung früher und in der anderen Richtung später in den Sättigunysbereich gelangt als ohne äußeres Magnetfeld. Damit kann die Magnetfeldmessung letztlich auf eine Messung des Tastverhältnisses, d.h. des Verhältnisses der Zeitdauer der positiven Amplitude zur Zeitdauer der negativen Amplitude zurückgeführt werden, wobei aus diesem Tastverhältnis über einen Mikrocomputer der tatsächliche Wert des zu messenden Magnetfeldes hergeleitet wird.

Die US-A-4 321 536 betrifft ebenfalls eine Vorrichtung zur Messung schwacher Magnetfelder mit einem Integrator 19 in der Auswerteschaltung. Dort wird auch über das Tastverhältnis der Meßspannung die Intensität des zu messenden Magnetfeldes ermittelt.

Der Integrator 19 dieser Vorrichtung darf keine Ausgangsspannung mit einem von ihm verursachten Gleichanteil erzeugen, weil sich damit zwangsläufig das Tastverhältnis seiner Ausgangsspannung ändern würde. Die Meßgenauigkeit einer solchen Meßvorrichtung wird daher durch den kaum vermeidbaren Gleichanteil der Ausgangssspannung beeinträchtigt.

Bei einer anderen vorbekannten, vergleichbaren Vorrichtung, der sogenannten "Förster-Sonde" wird das Frequenzspektrum beurteilt, wofür selektive und teuere Filter benötigt werden. Durch die Filterung und verschiedene Nichtlinearitäten wird die Verstärkung begrenzt. Der Erfindung liegt die Aufgabe zugrunde, eine Vorrichtung der eingangs genannten Art so auszugestalten, daß eine besonders hohe Empfindlichkeit erreicht wird, so daß insbesondere kleine Änderungen von Magnetfeldern bestimmt werden können.

Diese Aufgabe wird erfindungsgemäß gelöst durch eine Vorrichtung nach Anspruch 1, mit einer der Meß-Spule nachgeordneten Integrator-Einrichtung, einer Anordnung zur Subtraktion des Gleichanteils bzw. Quasigleichanteils der Ausgangsspannung und einer Einrichtung zur Erfassung der Beträge der Maxima aufeinanderfolgender Halbwellen des Ausgangssignales ($U_x$) der Subtraktionsanordnung.

In Übereinstimmung mit dem Vorgehen gemäß der DE-A-33 45 712 wird also auch bei der erfindungsgemäßen Lösung einer durch die Magnetisierungskurve (Hysterese) und das von außen einwirkende Gleichfeld bewirkte

Verzerrung der Halbwellen der Meß-Spannung untersucht. Jedoch wird aus dieser Verzerrung nicht der Unterschied der Zeitpunkte der Erreichung der Sättigungsmagnetisierung abgeleitet, sondern unter Ausschaltung von Gleichanteilen die Verzerrung der Meßkurven aufgrund des zu messenden äußeren Feldes selbst erfaßt, d.h. da die vermessenen Signale keinen Gleichanteil enthalten, kann durch Verstärkung des integrierten Signals eine außerordentlich hohe Empfindlichkeit erzielt werden, welche nur durch das Rauschen der verwendeten Verstärker begrenzt ist. Hierdurch wird bei geringem Aufwand ein weiter Meßbereich und eine hohe Empfindlichkeit ermöglicht. Darüber hinaus kann durch eine oder mehrere Kompensationsspulen ein äußeres Grundmagnetfeld, wie z.B. das Erdmagnetfeld, relativ einfach wegkompensiert werden, so daß besonders gut auch sehr kleine relative Magnetfeldänderungen bestimmt werden können, wie dies z.B. bei der Verwendung für Sensoren für bewegte Metallteile oder bei der Bodenuntersuchung in der Archeologie oder Geologie wünschenswert ist.

Bei einer günstigen Ausführungsform ist vorgesehen, daß die Einrichtung zur Bildung der Differenz der Beträge der Maxima zweier aufeinanderfolgender Halbwellen eine in Abhängigkeit vom Vorzeichen der anliegenden Spannung arbeitende Umschalteinrichtung, eine jedem Schalt-Ausgang der Umschalteinrichtung nachgeordnete Sample and Hold-Anordnung und eine den Ausgängen der Sample and Hold-Anordnungen nachgeordnete Addiereinrichtung umfaßt.

Gemäß einer anderen vorteilhaften Ausführungsform ist vorgesehen, daß zur Bildung der Meß-Spannung zwei identische, jedoch umgekehrt gewickelte Meß-Spulen in Reihe geschaltet sind, daß diese mit der Integratoreinrichtung verbunden sind, dem die Einrichtung zur Bildung zur Subtraktion des Gleich- vom Wechselspannungsanteil nachgeschaltet ist. Diese einfache Möglichkiet der Erzeugung zweier entgegengerichteter Meß-Spannungen läßt sich sowohl so realisieren, daß auf ein und denselben Kern die Meß-Spulen mit entgegengesetztem Wicklungssinn aufgebracht und hintereinandergeschaltet werden, oder daß zwei vollständige Spulen-Kern-Anordnungen verwendet und hintereinandergeschaltet werden.

In einer besonders einfachen Ausgestaltung umfaßt die Subtraktionseinrichtung einen Tiefpaß und einen Differenzverstärker, dessen einer Eingang direkt und dessen anderer Eingang über einen Tiefpaß mit dem Ausgang der Integrationseinrichtung verbunden ist.

Zur Durchführung von Relativmessungen und zur Kompensation eines äußeren Störfeldes erweist es sich als günstig, daß der Subtraktionseinrichtung eine Regelanordnung nachgeschaltet ist, deren Ausgang mit einer auf dem Kern angeordneten Kompensationsspule verbunden ist. Hierdurch kann bei statischen Ausgangsbedingungen das Meßsignal zu Null geregelt werden. Grundsätzlich ist es auch möglich, anstelle der Verwendung einer Regeleinrichtung das Ausgangssignal manuell zu Null zu kompensieren.

Weitere Merkmale, Vorteile und Einzelheiten der Erfindung ergeben sich aus der folgenden Beschreibung einer bevorzugten Ausführungsform anhand der Zeichnung. Dabei zeigen

Fig. 1 ein schematisches Blockschaltbild einer ersten Ausführungsform einer erfindungsgemäßen Vorrichtung,

Fig. 2 den Verlauf der Meßspannungen und deren Umwandlung und Auswertung bei dieser Ausführungsform,

Fig. 3 ein schematisches Blockschaltbild einer zweiten Ausführungsform einer erfindungsgemäßen Vorrichtung und

Fig. 4 den Verlauf der charakteristischen Spannungen bei dieser zweiten Ausführungsform.

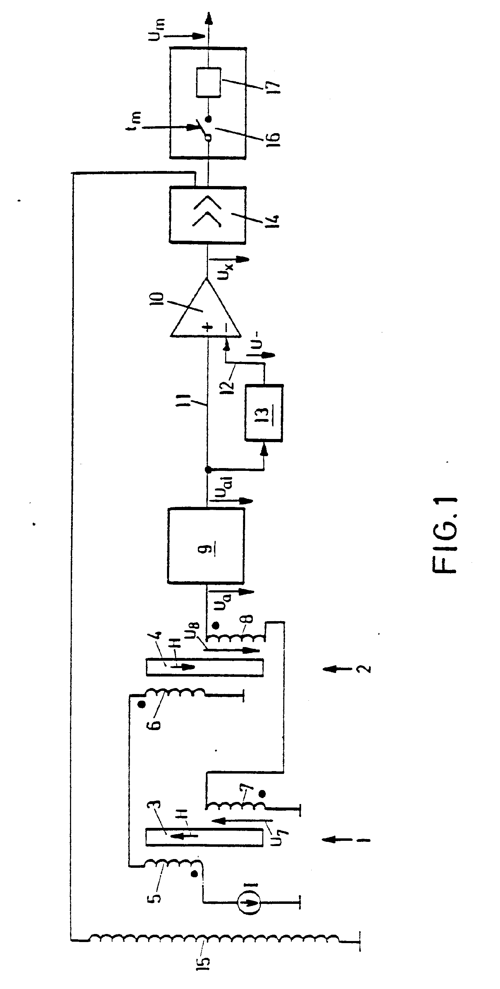

Bei der in Fig. 1 dargestellten Ausführungsform sind zwei Meß-Sonden 1, 2 vorgesehen, wovon jede einen Kern 3, 4 aus einem Material mit hoher Permeabilität, z.B. aus amorphen Metallen, sowie je eine Spule 5, 6 zum Anlegen eines Wechselstroms und eine Meßspule 7, 8 umfaßt. Die Spulen 5, 6 der beiden Sonden 1, 2 sind derart in Reihe geschaltet, daß sie von dem gleichen erregenden Wechselstrom I von z.B. 1 kHz durchflossen werden. Die untereinander identischen Spulen 7, 8 sind mit entgegengesetzter Wicklungsrichtung in Reihe geschaltet, so daß hierdurch eine Anordnung zur Bildung der Differenz der Beträge der beiden Halbwellen der Wechselspannungen U7 und U8 gebildet wird.

Der resultierende Meßstrom bzw. die korrespondierende Meß-Spannung $U_a$ wird einer Integrationseinrichtung 9 zugeführt. Die Integrationseinrichtung 9 dient zur Ableitung des magnetischen Flusses $\phi$ aus der durch die Induktion in den Meß-Spulen 7, 8 erhaltenen Meßspannung $U_a$, welche der zeitlichen Ableitung des zu messenden magnetischen Flusses $\phi$ proportional ist.

An die Eingänge eines Differenzverstärkers 1o wird über eine Leitung 11 das Ausgangssignal $U_{ai}$ der Integrationseinrichtung 9 direkt und über eine Leitung 12 das entsprechende Signal nach Filterung durch einen Tiefpaß 13 gelegt. Demzufolge werden am Ausgang des Differenzverstärkers 1o nur noch Signale ohne Gleichanteile auftreten und können durch im einzelnen nicht dargestellte Verstärkereinrichtungen verstärkt werden. Das Ausgangssignal $U_x$ des Differenzverstärkers 1o wird einer Regeleinrichtung 14 zugeführt, deren Ausgang mit einer Kompensationsspule 15 verbunden ist. Die Regeleinrichtung 14 dient dazu, bei der Messung von relativen Feldstärkenänderungen ein bestehendes magnetisches Grundfeld, wie z.B. das Erdfeld oder ein niederfrequentes Störfeld wie es durch elektrisch getriebene Züge u.dgl. auftritt (16 2/3 Hz), zu kompensieren. Die Regeleinrichtung 14 weist eine derartige Regelkonstante auf, daß die Nachregelung der Kompensation durhc die Kompensationsspule 15 deutlich langsamer erfolgt als die zu vermessenden relativen Feldänderungen.

Der Regeleinrichtung 14 ist eine Steuer-Einrichtung 16 für den Abtastzeitpunkt der Meßgröße und ein Analogspeicher 17 zur Abspeicherung und Ausgabe des Meßsignals nachgeschaltet. Durch eine geeignete Wahl des Abtastzeitpunktes durch die Einrichtung 16 im Maximum des Meßsignals nach der Differenzbildung des Betrags der beiden Halbwellen wird eine maximale Meßgenauigkeit erreicht und des kann auf das Vorsehen von Gleichrichtereinrichtungen verzichtet werden.

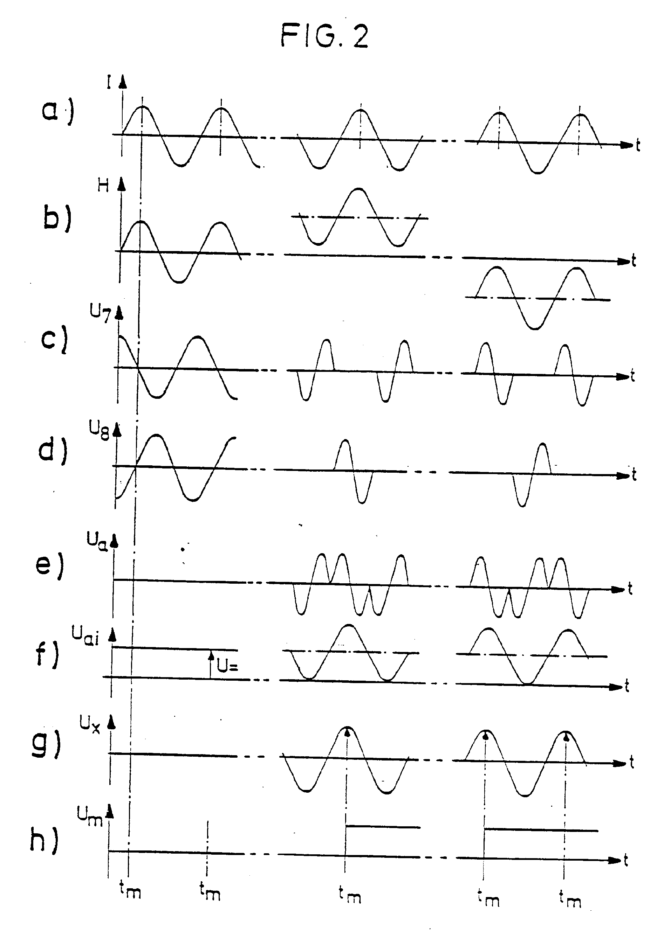

In Fig. 2 ist der Signalverlauf in Abhängigkeit von der Zeit an verschiedenen Stellen der in Fig. 1 dargestellten Schaltung zur Veranschaulichung der Arbeitsweise der erfindungsgemäßen Vorrichtung dargestellt. Dabei ist im ersten Abschnitt kein zu detektierendes Feld, im zweiten Abschnitt ein Feld in positiver und im dritten Abschnitt in negativer Richtung dem sinusförmigen Feld überlagert.

In Fig. 2a ist der Verlauf des erregenden Stromes 3 in den Spulen 5 und 6 in Abhängigkeit von der Zeit dargestellt.

In Fig. 2b ist die Feldstärke H in den Magnetkernen 3 und 4 dargestellt.

In Fig. 2c und 2d ist der Verlauf der um 18o° gegeneinander phasenverschobenen induzierten Spannungen U8 bzw. U7 in den Spulen 7 und 8 dargestellt, wobei die sinusförmigen Kurven aus Fig. 2a durch die Überlagerung des zu messenden äußeren Gleichfeldes in den Sättigungsbereich der Kerne 3 und 4 verzerrt sind.

Durch die Reihenschaltung der in umgekehrter Richtung gewickelten Meß-Spulen 7, 8 wird ein Meß-Signal $U_a$ der in Fig. 2e dargestellten Form erhalten, das auf den Eingang der Integrationseinrichtung 9 gelegt wird.

In Fig. 2f tritt das Integrations-Signal $U_{ai}$ auf, dessen vom Integrator verursachter Gleichanteil U= vom Tiefpaß ausgesiebt und als U- am Minuseingang des Differenzverstärkers 1o anliegt.

In Fig. 2g ist das Ausgangssignal $U_x$ des Differenzverstärkers 1o dargestellt.

Zum Zeitpunkt $t_m$ wird, wie in Fig. 2h eingezeichnet, der Meßwert $U_m$ erfaßt, und jeweils bis zur nächsten Messung gespeichert. Der Zeitpunkt $t_m$ wird hier durch den Scheitelwert des erregenden Wechselstromes I gemäß Fig. 2a bestimmt.

Mit der erfindungsgemäßen Sonde können durch die Vermeidung von Gleichanteilen im Ausgangssignal $U_x$ Empfindlichkeiten in der Größenordnung von 1pT erreicht werden, wobei die Empfindlichkeit im wesentlichen durch das Rauschen der Verstärker begrenzt wird.

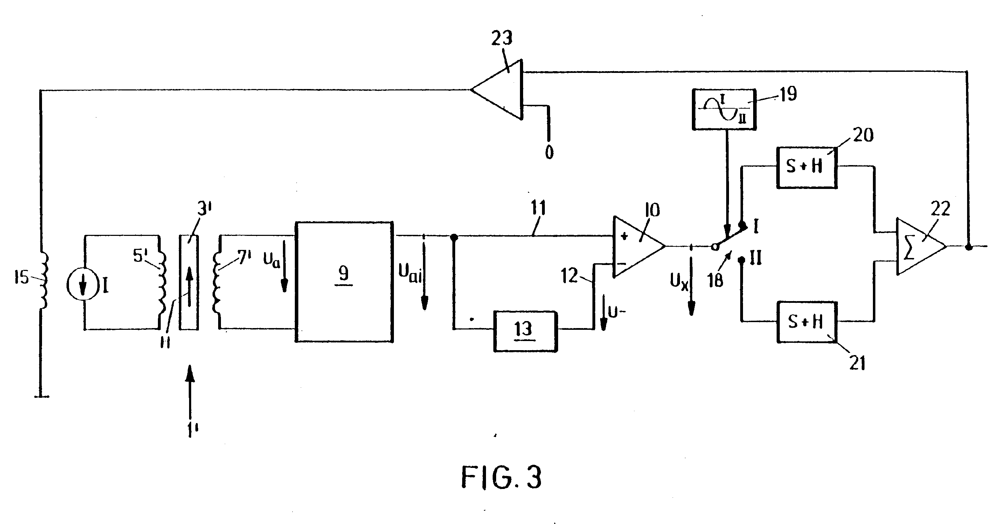

Bei der in Fig. 3 dargestellten Ausführungsform ist lediglich eine Meßsonde 1′ vorgesehen, welche einen Kern 3′ aus einem Material mit hoher Permeabilität sowie eine Spule 5′ zum Anlegen eines Wechselstroms I und eine Meßspule 7′ umfaßt.

Wie bei dem Ausführungsbeispiel nach Fig. 1 ist der Meßspule 7′ eine Integrationseinrichtung 9 nachgeordnet. Das Ausgangssignal $U_{ai}$ der Integrationseinrichtung 9 wird ebenso wie bei dem Ausführungsbeispiel nach Fig. 1 über eine Leitung 11 direkt und über eine Leitung 12 über einen Tiefpaß 13 den Eingängen eines Differenzverstärkers 1o zugeführt, welchem ein Schalter 18 nachgeordnet ist. Der Schalter 18 weist zwei Schaltstellungen I und II auf, wobei der Schalter 18 über eine Umschaltanordnung 19 derart betätigt wird, daß er bei einer positiven Halbwelle der Eingangsspannung in die Schaltstellung I und bei einer negativen Halbwelle der Eingangsspannung in eine Schaltstellung II gebracht wird.

Den Kontakten des Schalters 18, welche den Schaltstellungen I bzw. II entsprechen, ist jeweils eine Sample and Hold-Anordnung nachgeordnet ist, welche so ausgelegt sind, daß sie jeweils das Maximum der ihnen zugeführten jeweiligen Halbwelle festhalten, wobei in der nachfolgenden Summiereinrichtung 22 die Differenz der beiden Halbwellen- Maxima entgegengesetzten Vorzeichens gebildet wird.

Das Ausgangssignal der Summiereinrichtung 22 wird dazu herangezogen, über eine Treiberstufe 23 eine Kompensationsspule 15 - wie im ersten Ausführungsbeispiel - so zu betreiben, daß ein zeitlich konstantes oder sich relativ zur Meßfrequenz langsam änderndes externes Magnetfeld zu Null kompensiert wird. DieZeitkonstante der Kompensations-Regelung wird dabei so ausgelegt oder eingestellt, daß demgegenüber vergleichsweise schnelle Magnetfeldänderungen, welche gemessen werden sollen, nicht wegkompensiert werden.

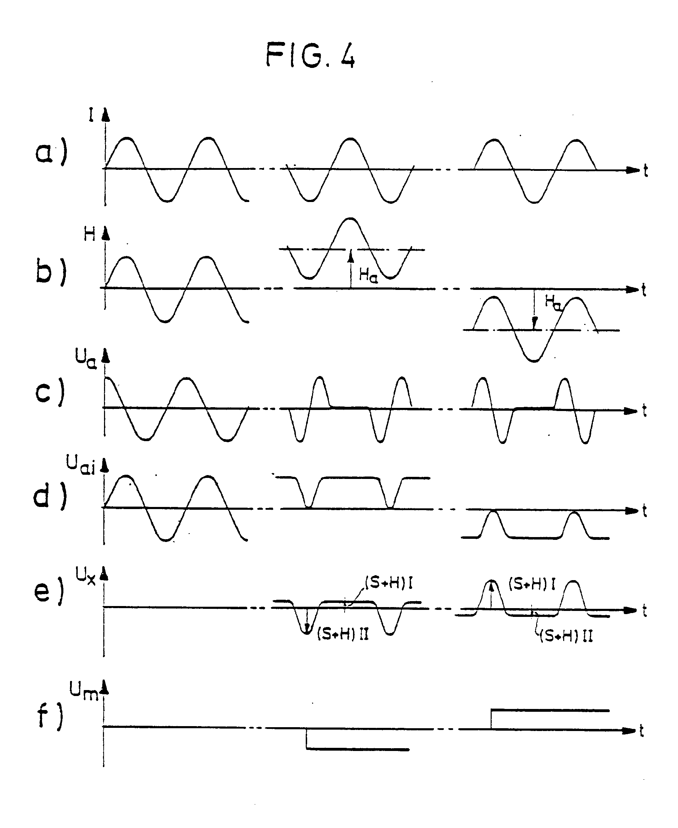

In Fig. 4 ist der Verlauf der Spannung an verschiedenen Punkten der in Fig. 3 dargestellten Schaltungsanordnung veranschaulicht.

In Fig. 4a ist der Verlauf des erregenden Wechselstromes I von 1 kHz in der Spule 5′ entsprechend dem Verlauf in Fig. 2a dargestellt.

In Fig. 4b ist der Verlauf der Feldstärke H dargestellt, welcher veranschaulicht, daß durch die Überlagerung eines äußeren Magnetfeldes $H_a$ die positive und negative Halbwelle aus der Nullinie verschoben werden. In Fig. 4c ist die in der Meßspule 7′ induzierte Spannung Ua dargestellt, die sich ohne bzw. bei Überlagerung eines äußeren Magnetfeldes Ha durch die Kernsättigung ergibt.

In Fig. 4d ist die Spannung $U_{ai}$ am Ausgang der Integrationseinrichtung 9 dargestellt, aus welcher der Gleichanteil noch auszufiltern ist.

In Fig. 4e ist die Spannung $U_x$ am Ausgang des Differenzverstärkers 1o ohne Gleichanteil dargestellt. Weiterhin ist in Fig. 4e eingezeichnet, wie die Sample and Hold-Einrichtungen 2o bzw. 21 in der Schaltstellung I bzw. II des Schalters 18 jeweils einen Maximalwert erfassen und abspeichern.

In Fig. 4f ist dann das Ausgangssignal $U_m$ am Ausgang des Addierers 22 dargestellt, welchem die beiden Maximal-Meßwerte der Sample and Hold-Einrichtungen 2o und 21 zugeführt werden. Dieses Ausgangssignal $U_m$ dient einerseits als Kompensationssignal für die Kompensationsspule 15 für langsame Feldänderungen oder Störfelder und stellt andererseits nach erfolgtem Abgleich das dem zu messenden Magnetfeld proportionale Meßsignal dar.

## Patentansprüche

1. Vorrichtung zur Messung eines zeitlich konstanten oder sich ändernden Magnetfeldes umfassend wenigstens einen Kern (3, 4 bzw. 3′) aus einem Material mit hoher Permeabilität, eine Spule (5, 6 bzw. 5′) zur Magnetisierung dieses Kerns über eine an die Spule angeschlossene Wechselstromquelle (I), eine Meßspule (7, 8 bzw. 7′), in welcher eine einer nachgeordneten Integrationseinrichtung (9) zugeführte Spannung (Ua) induziert wird entsprechend dem in dem Kern aufgrund des durch den angelegten Wechselstrom und das äußere, zu messende Magnetfeld erzeugten resultierenden Magnetfeldes, gekennzeichnet durch eine der Integrationseinrichtung (9) nachgeordnete Subtraktionseinrichtung (10, 13) zur Subtraktion eines von der Integrationseinrichtung (9) verursachten Gleichanteils bzw. Quasigleichanteils (U=) der Ausgangsspannung $(U_{ai})$ der Integrationseinrichtung (9) und eine Einrichtung (16, 17 bzw. 18 bis 22) zur Erfassung der Beträge der Maxima aufeinanderfolgender Halbwellen des Ausgangssignales $(U_x)$ der Subtraktionseinrichtung (10, 13).

2. Vorrichtung nach Anspruch 1, dadurch gekennzeichnet, daß der Subtraktionseinrichtung (10, 13) eine Einrichtung (18 bis 22) zur Erfassung der Maximabeträge und zur Bildung der Differenz der Maximabeträge zweier aufeinanderfolgender Halbwellen nachgeschaltet ist.

3. Vorrichtung nach Anspruch 2, dadurch gekennzeichnet, daß die Einrichtung zur Bildung der Differenz der Beträge der Maxima zweier aufeinanderfolgender Halbwellen eine Umschalteinrichtung (18), die in Abhängigkeit vom Vorzeichen der an ihr anliegenden Spannung (U) arbeitet und die der Spannung an der Magnetisierungsspule (5, 5′) entspricht sowie eine jedem Schaltausgang der Umschalteinrichtung (18) nachgeordnete Sample-and-Hold-Anordnung (20 bzw. 21) und eine den Ausgängen der Sample-and-Hold-Anordnungen (20 bzw. 21) nachgeordnete Addiereinrichtung (22) umfaßt.

4. Vorrichtung nach Anspruch 1, dadurch gekennzeichnet, daß zwei identische, jedoch umgekehrt gewickelte Meßspulen (7, 8) in Reihe geschaltet und diese mit der Integrationseinrichtung (9) verbunden sind.

5. Vorrichtung nach Anspruch 1, dadurch gekennzeichnet, daß die Subtraktionseinrichtung einen Tiefpaß (13) und einen Differenzverstärker (10) umfaßt, dessen einer Eingang (+) direkt und dessen anderer Eingang (-) über den Tiefpaß (13) an den Ausgang der Integrationseinrichtung (9) angeschlossen sind.

6. Vorrichtung nach Anspruch 1, dadurch gekennzeichnet, daß der Subtraktionseinrichtung (10, 13) eine Regeleinrichtung (14) nachgeordnet ist, deren Ausgang mit einer Spule (15) zur Kompensation eines Gleichfeldes im Kern (3) verbunden ist.

## Claims

1. Device for measuring a magnetic field which is constant or varies with time, comprising at least one core (3, 4 and 3′) of a material with high permeability, a coil (5, 6 and 5′) for magnetising this core via an alternating-current source (I) connected to the coil, a measuring coil (7, 8 and 7′), in which a voltage (Ua) supplied to a subsequent integration device (9) is induced in accordance with the resulting magnetic field generated in the core due to the applied alternating current and the external magnetic field to be measured, characterised by a subtraction device (10, 13) following the integration device (9) for subtracting a direct component or quasi-direct component (U=), caused by the integration device (9), of the output voltage ($U_{ai}$) of the integration device (9) and a device (16, 17 and 18 to 22) for detecting the amounts of the peaks of successive half waves of the output signal ($U_x$) of the subtraction device (10, 13).

2. Device according to Claim 1, characterised in that the subtraction device (10, 13) is followed by a device (18 to 22) for detecting the amounts of the peaks and for forming the difference between the amounts of the peaks of two successive half waves.

3. Device according to Claim 2, characterised in that the device for forming the difference between the amounts of the peaks of two successive half waves comprises a switch-over device (18), which operates in dependence on the sign of the voltage (U) applied to it and which corresponds to the voltage across the magnetising coil (5, 5′) and a sample-and-hold arrangement (20 and 21) following each switching output of the change-over device (18) and an adding device (22) following the outputs of the sample-and-hold arrangements (20 and 21).

4. Device according to Claim 1, characterised in that two identical but oppositely wound measuring coils (7, 8) are connected in series and these are connected to the integration device (9).

5. Device according to Claim 1, characterised in that the subtraction device comprises a low-pass filter (13) and a differential amplifier (10), one input (+) of which is connected directly and the other input (-) of which is connected via the low-pass filter (13) to the output of the integration device (9).

6. Device according to Claim 1, characterised in that the subtraction device (10, 13) is followed by a control device (14), the output of which is connected to a coil (15) for compensating for a direct field in the core (3).

## Revendications

1. Dispositif pour mesurer un champ magnétique constant ou variable dans le temps comprenant au moins un noyau (3, 4 ou 3′) en une matière à haute perméabilité, une bobine (5, 6 ou 5′) pour magnétiser ce noyau au moyen d'une source de courant alternatif (I) raccordée à la bobine, une bobine de mesure (7, 8 ou 7′), dans laquelle est induite une tension (Ua) appliqué à un dispositif d'intégration (9) branché en aval, tension correspondant au champ magnétique résultant produit dans le noyau du fait du courant alternatif appliqué et du champ magnétique extérieur à mesurer, dispositif caractérisé par un dispositif (10, 13) de soustraction disposé en aval du dispositif d'intégration (9) par rapport à une fraction continue ou d'une fraction quasi-continue (U=) de la tension de sortie ($U_{ai}$) du dispositif d'intégration (9) causée par le dispositif d'intégration (9), disposé en aval du dispositif d'intégration, et un dispositif (16, 17 ou 18 à 22) pour détecter les montants des demi-ondes successives maximales du signal de sortie ($U_x$) du dispositif de soustraction (10, 13).

2. Dispositif selon la revendication 1, caractérisé en ce qu'au dispositif de soustraction (10, 13) est associé en aval un dispositif (18 à 22) pour détecter les montants maximals et pour former la différence des montants maximals de deux demi-ondes successives.

3. Dispositif selon la revendication 2, caractérisé en ce que le dispositif servant à former la différence des montants des valeurs maximales de deux demi-ondes successives comprend un dispositif de commutation (18), qui travaille en fonction du signal de la tension (U) qui lui est appliquée et qui correspond à la tension sur la bobine (5, 5') de magnétisation ainsi qu'un dispositif (20 et 21) échantillonnage et maintien monté en aval à chaque sortie du dispositif de commutation (18) et un dispositif d'addition (22) disposé en aval des sorties des dispositifs échantillonnage et maintien (20 ou 21).

4. Dispositif selon la revendication 1, caractérisé en ce que deux bobines de mesure (7, 8) identiques, mais bobinées en sens inverse sont montées en série et que celles-ci sont reliées au dispositif (9) d'intégration.

5. Dispositif selon la revendication 1, caractérisée en ce que le dispositif de soustraction comprend un filtre passe-bas (13) et un amplificateur différentiel (10), dont une entrée (+) est raccordée directement et l'autre entrée (-) est raccordée par l'intermédiaire du filtre passe-bas (13) à la sortie du dispositif d'intégration (9).

6. Dispositif selon la revendication 1, caractérisé en ce que le dispositif de soustraction (10, 13) est disposé en aval d'un dispositif de régulation (14), dont la sortie est reliée à une bobine (15) pour compenser un champ continu dans le noyau (3).

FIG.1

# FIG. 2

FIG.3

EP 0 329 652 B1

FIG. 4